# EUROPEAN PATENT SPECIFICATION

(11) **EP 2 100 849 B1**
(45) Date of publication and mention of the grant of the patent: **22.09.2010**
(21) Application number: 08152673.3
(22) Date of filing: 13.03.2008
(51) Int. Cl.: B81C 1/00, G01N 21/65

(54) **Method of manufacturing molecular plasmonic nanostructures**
Verfahren zur Herstellung von molekular plasmonischen Nanostrukturen
Procédé de fabrication de nanostructures plasmoniques moléculaires

(43) Date of publication of application: 16.09.2009
(73) Proprietor: Institut de Ciències Fotòniques, Fundació Privada, 08860 Castelldefels, Barcelona (ES); Institució Catalana de Recerca i Estudis Avançats, 08010 Barcelona (ES)
(72) Inventor: Hoogenboom, Jacob, P., 08860 Castelldefels (Barcelona) (ES); Lereu, Aude L., 08860 Castelldefels (Barcelona) (ES); Van Hulst, Niek F., 08860 Castelldefels (Barcelona) (ES)
(74) Representative: Carpintero Lopez, Francisco

(56) References cited:
- US-A1- 2006 279 738
- SPADAVECCHIA ET AL: "Surface plamon resonance imaging of DNA based biosensors for potential applications in food analysis" BIOSENSORS & BIOELECTRONICS, ELSEVIER SCIENCE PUBLISHERS, BARKING, GB, vol. 21, no. 6, 15 December 2005 (2005-12-15), pages 894-900, XP005135313 ISSN: 0956-5663
- BARBILLON ET AL: "Electron beam lithography designed chemical nanosensors based on localized surface plasmon resonance" SURFACE SCIENCE, NORTH-HOLLAND PUBLISHING CO, AMSTERDAM, NL, vol. 601, no. 21, 26 October 2007 (2007-10-26), pages 5057-5061, XP022315311 ISSN: 0039-6028
- HOA X D ET AL: "Modelling and implementation of a novel SPR biointerface for time-effective detection of sepsis biomarkers" APPLICATION -SPECIFIC SYSTEMS, ARCHITECTURES AND PROCESSORS, 2007. ASA P. IEEE INTERNATIONAL CONF. ON, IEEE, PI, 1 September 2006 (2006-09-01), pages 30-33, XP031201982 ISBN: 978-1-4244-1026-2

## Description

### FIELD OF THE INVENTION

The present invention relates to the field of nanotechnology, more particular it relates to a method for manufacturing molecular plasmonic nanostructures, molecular plasmonic nanostructures obtainable by said method and their use, especially in active molecular-scale devices.

### BACKGROUND OF THE INVENTION

Exploitation of molecular properties of a single molecule is an important factor in nanotechnology, leading to technological miniaturization and subsequently to the construction of active molecular-scale devices. The desired use of electronic or optical properties of a single molecule requires embedding the molecule in a nanostructured environment that provides means to address, tailor, or control this functionality. Suitable interfaces of particular interest are nanoscale resonators thanks to their strongly localized electromagnetic field modes both in the spatial and in the frequency domains. Especially plasmon resonances in metallic structures are known to give rise to giant, strongly localized field enhancement, which is used to locally enhance driving and/or output field or to tune and control functional properties of the embedded molecule.

Metallic plasmon nanostructures can be in general made either via chemical synthesis techniques, including self-assembly, or via surface lithography techniques. In both approaches attempts have been made to incorporate desired molecular functionality.

Metallic nanoparticles can be directly coated with a molecular layer, or a spacer layer can first be grafted to tune the distance between functional molecules and metal structure. Coatings can be tuned from monolayer to few or single molecules per particle by adjusting reagent concentrations. Functional molecules can also be used as a linker between different nanoparticles, thus locating single or few molecules inside a gap between two nanoparticles. However in the above approaches, molecular positioning on the nanoparticles outer surface occurs on a random basis. Moreover, the use of chemical synthesis techniques usually limits the type and morphology of the plasmonic nanostructure to their chemical possibilities.

Whereas the use of lithographic techniques enables in principle to obtain any desired structure of the plasmonic nanostructure thus fabricated, nevertheless desired positioning of functional molecules, which is usually effected with the use of a spincoating technique, clearly results in a wide variety of distances between the plasmonic nanostructure and different molecules. Moreover, these distances cannot be a priori controlled. Distance-control can be achieved by applying similar molecular functionalization techniques to the surface-bound nanostructure as to chemically synthesized nanostructures. Thus, the plasmonic nanostructures can be directly coated with functional molecules or alternatively, a spacer layer can first be attached to the nanostructures and then the functional molecules. Nevertheless this approach also suffers from the same drawbacks as mentioned above, namely that positioning on the outer surface still occurs on a random basis.

Another approach relies on the use of one or more nanoholes or nanowells in a metal film. Such nanoholes can operate as plasmonic nanocavities. If the nanohole exposes an underlying substrate, functional molecules can be grafted onto this secondary substrate inside the nanohole. Such solution, for example, has been disclosed in the European Patent No. EP 1353179. However the main limitation of this technique is that all non-metal parts of the substrate are also being coated and that it thus cannot be used for localized patterning close to nanometer-scale plasmonic structures, such as resonant nanoantennas.

Desired, deterministic, nanometer-scale localized positioning of functional molecules with respect to a surface bound plasmonic nanostructure has so far not been demonstrated.

According to the above, there is the need in the state of the art of providing mutually well-defined positioning of both functional molecules and metallic nanostructures with nanometer-scale precision, resulting in molecular-scale devices having desired activity.

### SUMMARY OF THE INVENTION

In one aspect the present invention relates to a method of manufacturing a molecular plasmonic nanostructure, which comprises the steps of:
a) forming of two distinct layers of conductive material consisting of a layer of upper conductor and a layer of lower conductor,
b) fabrication of a plasmonic nanostructure onto a layer of upper conductor with the use of a charged particle beam technique,
c) etching the surface through the layer of upper conductor with the use of a charged particle beam technique, thus exposing the desired area of a layer of lower conductor, and
d) functionalising the exposed area with the use of desired molecular unit.

The method of the present invention enables controlled and localized patterning resulting in a desired molecular plasmonic nanostructure suitable for use as electronic and optical nanoscale devices.

The method of the invention enables fabrication of a molecular plasmonic nanostructure, where functional molecules as well as plasmonic elements can be placed at a predefined position with respect to the nanostructure with nanoscale precision.

In another aspect the present invention refers to molecular plasmonic nanostructure obtainable by the claimed process, which possesses the desired characteristics required in the nanotechnology sector of industry, finding many applications in a wide range of nanoscale devices.

Yet in another aspect the present invention relates to the use of the molecular plasmonic nanostructure especially in sensing and detection, light harvesting and energy conversion, photon sources, all-optical components including transistors, and electronic-optical interfacing.

### BRIEF DESCRIPTION OF THE FIGURES

**Figure 1** is a schematic view of a method for manufacturing a molecular plasmonic nanostructure, wherein the following numerical references refer to the following elements: 1 to an upper conductor, 2 to a lower conductor, 3 to a supporting substrate, 4 to a resist material, 5 to a plasmonic material, 6 to a molecular unit and 7 to a spacer.
**Figure 2** is a top view of the plasmonic nanostructure obtainable by the method as illustrated on figure 1.
**Figure 3** is a schematic view of a method for manufacturing molecular plasmonic nanostructure having inverted pattern, wherein the following numerical references refer to the following elements: 1 to an upper conductor, 2 to a lower conductor, 3 to a supporting substrate, 4 to a resist material, 5 to a plasmonic material and 6 to a molecular unit.
**Figure 4** is top view of the plasmonic nanostructure obtainable by the method as illustrated on figure 3.
**Figure 5** is a schematic view of a method for manufacturing molecular plasmonic nanostructure with the use of a surface coating, wherein the following numerical references refer to the following elements: 1 to an upper conductor, 2 to a lower conductor, 5 to a plasmonic material, 6 to a molecular unit, 7 to a spacer and 8 to a surface coating.
**Figure 6** is a schematic view of a method for manufacturing molecular plasmonic nanostructure involving depositing of a plasmonic material prior to a resist material, wherein the following numerical references refer to the following elements: 9 to an upper conductor, 2 to a lower conductor, 10 to a resist material and 11 to a plasmonic material.
**Figure 7a** shows a top view of plasmonic elements.
**Figure 7b** represents a view of plasmonic elements having two opposing faces.
**Figure 7c** represents a view of plasmonic elements in a form of nanoantenna structure.
**Figure 7d** represents a view of plasmonic elements having two or more opposing faces.
**Figure 8****:** (a) is a Scanning electron microscopy image of an array of gold nanoantennas on a Cr/ITO substrate after Focused Ion Beam milling with a gap milled in the middle of the antennas in the upper two rows, with ion beam dose increasing from the upper left corner to the right antenna in the second row; (b) is the Optical transmission and (c) a confocal fluorescence microscopy image of the same area after functionalization.

### DETAILED DESCRIPTION OF THE INVENTION

One aspect of the invention refers to a method of manufacturing a molecular plasmonic nanostructure, hereinafter referred to as the method of the invention, which comprises the steps of:
a) forming of two distinct layers of conductive material consisting of a layer of upper conductor 1, 9 and a layer of lower conductor 2,
b) fabrication of a plasmonic nanostructure onto a layer of upper conductor 1, 9 with the use of a charged particle beam technique,
c) etching the surface through the layer of upper conductor 1, 9 with the use of a charged particle beam technique, thus exposing the desired area of a layer of lower conductor 2,
d) functionalising the exposed area with the use of desired molecular unit 6.

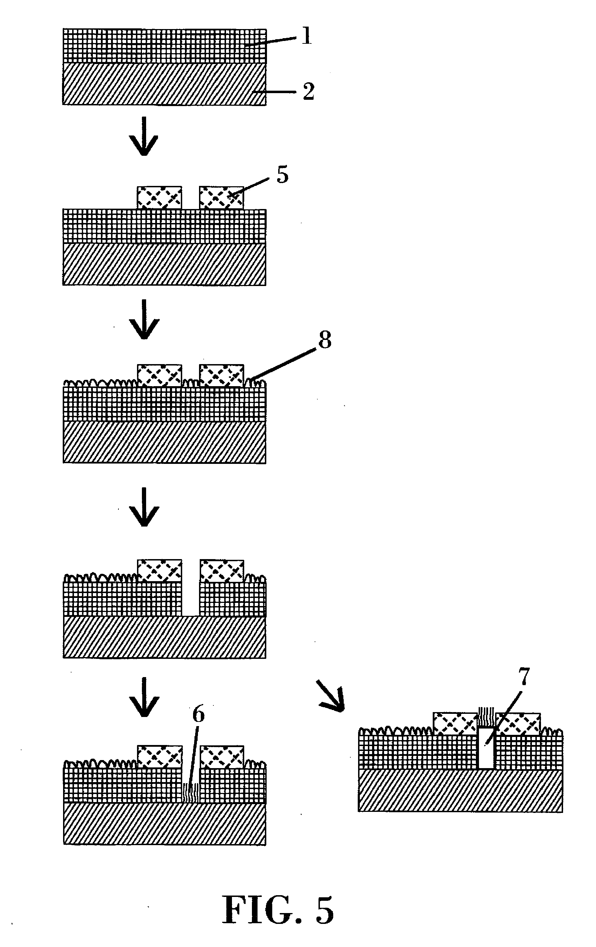

Optionally, the method of the invention further comprises after step (b) applying a surface coating 8 onto a layer of upper conductor, as illustrated on figure 5. Surface coating can be applied onto a layer of upper conductor prior to etching the surface with the use of a charged particle beam technique in order to increase the affinity difference between the top surface of the upper conductor and the lower conductor.

As used throughout the description the terms "a" and "the" may refer indistinctly to the singular or the plural form.

The term distinct refers to the fact that, the upper conductor (1, 9) and the lower conductor (2) consist necessarily of a different conductive material having thus different affinity for a molecular unit (6) or a spacer (7).

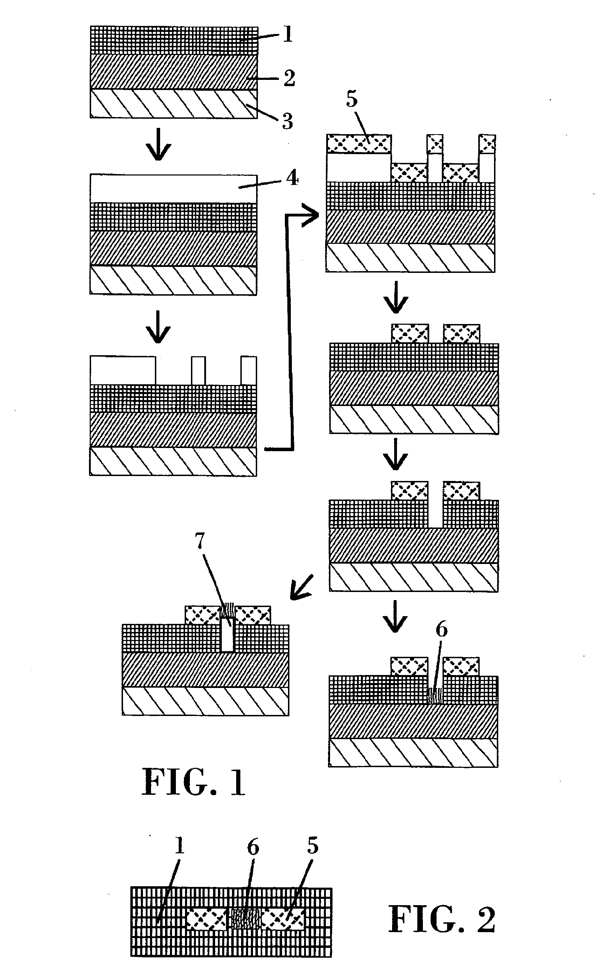

In one particular embodiment of the method of the present invention, as illustrated on figure 1, step b) comprises the steps of:
i) depositing a resist material 4 onto layer of upper conductor 1,
ii) writing a pattern in said resist material 4 with the use of a charged particle beam lithography technique,
iii) developing resist material 4,
iv) depositing a plasmonic material 5, and
v) removing remaining resist material 4.

Top view of the plasmonic nanostructure thus obtained has been illustrated on figure 2.

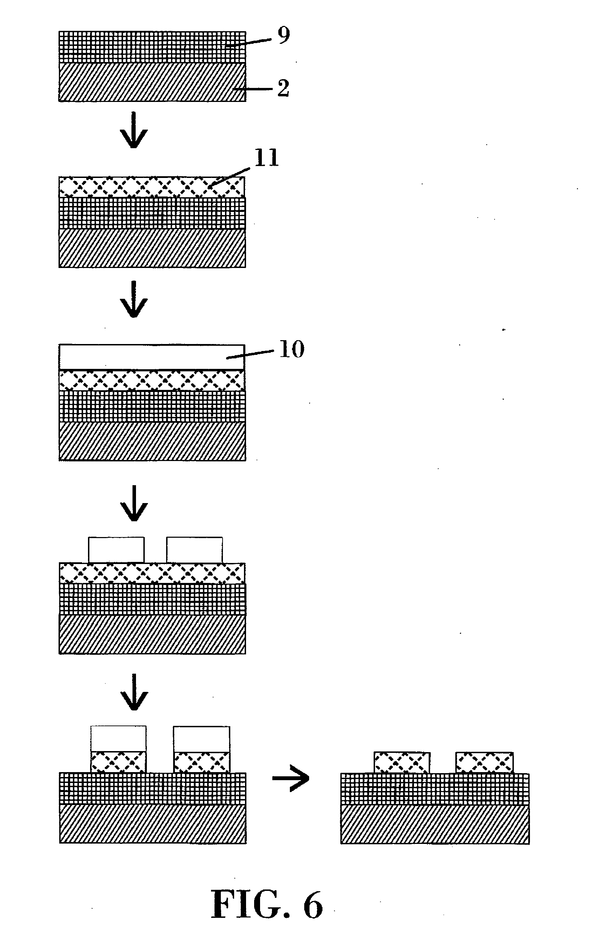

According to another embodiment of the method of the present invention, as illustrated on figure 6, step b) comprises the steps of:
i) depositing a plasmonic material 11 onto layer of upper conductor 9,
ii) depositing a resist material 10 onto a formed layer of deposited plasmonic material 11,
iii) developing resist material 10,
iv) writing a pattern in resist material 10 with the use of a charged particle beam lithography technique,
v) etching the surface of exposed plasmonic material 11 with the use of a charged particle beam technique, and vi) removing remaining resist material 10.

Top view of the plasmonic nanostructure thus obtained is the same as the one that has been illustrated on figure 2.

Preferably, the step of depositing the resist material 4 or 10, is carried out by spincoating technique, but other techniques may also be used, such as evaporating or sputtering.

Preferably, writing a pattern in the resist material 4 or 10 is carried out by electron beam lithography, whereas etching the surface of exposed plasmonic material 11 is carried out by reactive ion etching technique.

Preferably, charged particle beam technique from step (c) is carried out by focused ion beam milling (FIBM). This etching technique allows local etching at a well-defined position through the layer of the upper conductor, exposing thus a small area, or multiple small areas, of the layer of the lower conductor. Generally, lateral sizes of the etched areas range from a few tens of nanometers up to several orders of magnitude larger. An etched area as small as 10 x 10 nm may also be achieved. The exposed area of the lower conductor can be subsequently functionalised by covalent or non-covalent chemical bonding or by adsorption of functional species.

According to a particular embodiment of the invention, step (d) of functionalising the exposed area is preceded with grafting or adsorbing a spacer 7 onto the exposed area in order to position the functional species with respect to the metallic structure in a direction perpendicular to the substrate. In a particular embodiment, to tune the position of the a RITC dye (molecular unit) with respect to the plasmonic material (Au bars) in the direction perpendicular to the substrate, a thin layer of SiO₂ is grown onto the exposed lower conductor parts, after which the APS-RITC construct was grafted onto this silica layer (see Example 3).

According to the invention, the layer of lower conductor 2 serves as the supporting substrate, or the layers of upper conductor 1 or 9 and lower conductor 2 can be coated onto a supporting substrate 3.

The upper conductor consists of a conductive material having different affinity to molecular unit 6 or spacer 7 than said lower conductor. In particular, said lower conductor must have higher chemical affinity to molecular unit 6 or spacer 7, than the upper conductor to achieve that the molecular unit 6 or spacer 7 does not substantially adhere to said upper conductor, and just adheres to the lower conductor. The term substantially refers to the fact that inventors believe that there might be some molecular units 6 or spacers 7 adhering somewhere to the surface albeit in extremely low quantities.

The upper conductor is selected from the group consisting of metals, metal oxides, doped semiconductors, conductive polymers and conductive carbon films. The conductive carbon film is for instance a carbon nanotube film.

Preferably, the upper conductor is a primer material for the metal, that is, the metal has higher adhesion to upper conductor as to lower conductor or supporting substrate. More preferably it is selected from the group consisting of chromium, chromium oxide, titanium and titania. In a most preferred embodiment chromium is used.

Its thickness is preferably a few nanometers, which facilitates focused ion beam etching, ensures transparency, and minimizes damping of the plasmon resonance, but it also can be of any reasonable thickness.

The lower conductor is a conductive material, selected from the group consisting of metals, metal oxides, doped semiconductors, inorganic semiconductors, conductive polymers, doped inorganic semiconductors and conductive carbon films. Preferably, it is selected from the group consisting of conductive materials transparent at optical wavelengths, such as ultraviolet (200-400nm), visible range (400-700nm), near-infrared (700-1400nm) and infrared (700nm-1mm, more preferably transparent at wavelengths in the visible range. As illustrative examples the following may be mentioned: indium tin oxide (ITO), (poly(3,4-ethylenedioxythiophene) (PEDOT), poly(3,4-ethylenedioxythiophene):poly(styrenesulfonate) (PEDOT:PSS) and carbon nanotubes. In a most preferred embodiment indium tin oxide (ITO) is selected. Nevertheless, non-transparent materials may also be used.

The experiments carried out by the inventors showed that the use of conductive oxides, gives the possibility of adhering a wide range of chemical and biological materials. However, use of other mentioned materials is also suitable.

Suitable molecular unit 6 to be functionalised and to put into practice the present invention may be, for instance, but not limited, a molecular unit selected form one of the following groups:
(i) optically active materials including, but not limited to fluorescent, luminescent or phosphorescent molecules, such as Rhodamine-B-isothiocyanate, nanoparticles, proteins, quantum dots or nanocrystals, light harvesting complexes, J-aggregates, H-aggregates;
(ii) biological materials including, but not limited to proteins, antibodies, antigens, amino acids, sugars, DNA, enzymes, nutraceuticals;
(iii) molecular or supramolecular receptors that have at least one functional group which specifically or non-specifically bind such as, but not limited to, -OH, - CHO, -COOH, -SH, -NH₂, or -CN;
(iv) polymer chains, such as polyelectrolytes; and
(v) a functional material selected from groups (i), (ii) and (iv) above, that has first been bound to a receptor selected from group (iii).

The surface coating 8 consists of an absorbed polymer film or a self-assembled monolayer. Said monolayer is chemically grafted onto upper conductor, either directly or alternatively after mild surface oxidation of the upper conductor. Suitable materials for the self-assembled monolayer are, for instance, alkylthiol, alkyl silane molecules, such as octadecyltrichlorosilane, or octyltrimethoxysilane, and, alkylcarboxylate. In a particular embodiment a monolayer of octyltrimethoxysilane is grafted onto an oxidized conductive layer, such as thermally oxidized silicon, ITO, or titania, in an ammonia-catalyzed wet chemical reaction. By the way of example, a polymer film of particular interest is a Langmuir-Blodgett film type.

The supporting substrate is selected from the group comprising conventional supporting solids or flexible materials and in a particular embodiment of the invention it is a solid glass plate.

Resist material may be a resist material suitable for electron beam lithography, such as a lift-off resist material, of positive or negative type. A preferred resist material to put the present invention into practice, is poly(methylmethacrylate) (PMMA). Subsequent removing of PMMA can be carried out with the use of dichloromethane.

The thickness of the PMMA layer is generally comprised between 120 and 150 nm, which is the preferable thickness for electron-beam lithography, whereas the thickness of plasmonic material is usually about 40nm, which is the preferable thickness for deposition and subsequent lift-off. However it must be noted that they can be of arbitrary thickness, which will in general depend on the required functionality. For instance, changing the thickness of the plasmonic layer may shift the resonance frequency of the structure, and the thickness of the PMMA layer may depend on the needed plasmonic layer thickness. Nevertheless, a skilled person in the art is able to easily set the parameters for his use.

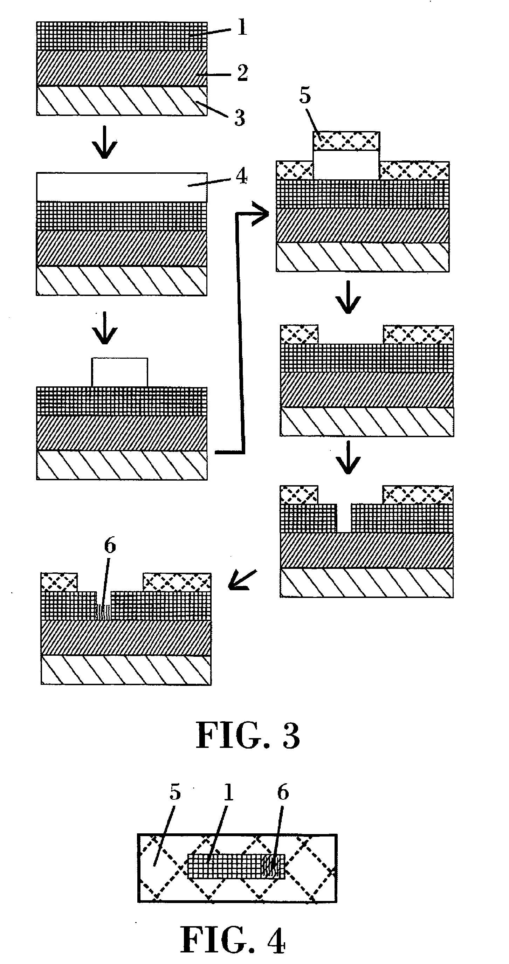

The use of a positive or negative resist material has influence on the shape and structure of the obtained nanostructure. Use of a positive type permits dissolution of the exposed parts of the resist prior to deposition of the plasmonic material, therefore the pattern written with the use of electron-beam technique becomes the shape of the nanostructure, as shown in figures 1 and 2. Whereas in case of a negative resist it is the other way round, i.e. all the parts of the resist that have not been exposed are dissolved. Thus, the obtained pattern written with the use of electron-beam technique is the inverse of the pattern finally created (inverted pattern), as illustrated on figures 3 and 4. This means that the whole area of the molecular plasmonic nanostructure is coated by the plasmonic material except for the pattern that was written with the electron beam technique. Subsequent use of for example focused ion beam milling allows to expose a small area of lower conductor inside of the formed hole, or inside many formed holes, which further permits desired localized functionalization.

According to the embodiment represented in figure 6 of the method of the invention, by depositing the plasmonic material prior to the resist material, the influence of positive respectively to negative resist material is exactly the other way round compared to the scheme above outlined.

Suitable spacers 7 comprise an inorganic compound, such as SiO₂ or a polymeric compound, comprising one or more layers of alternating positively and negatively charged polyelectrolytes, for instance, poly(sodium styrene sulfonate) (PSSS) and poly(allylamine hydrochloride) (PAH). According to a preferred embodiment, SiO₂ is used.

Whereas a plasmonic material can be any plasmonic material, such as a metal or doped semiconductor, that supports a collective oscillation of free electrons (plasmon), preferably a metal, and more preferably silver or gold are used. Suitable plasmonic materials are also p-type doped silicon, n-type doped silicon and gallium arsenide.

Another aspect of the invention refers to molecular plasmonic nanostructure obtainable by the method of the invention.

In one particular embodiment, a molecular plasmonic nanostructure consists of at least one separate plasmonic element.

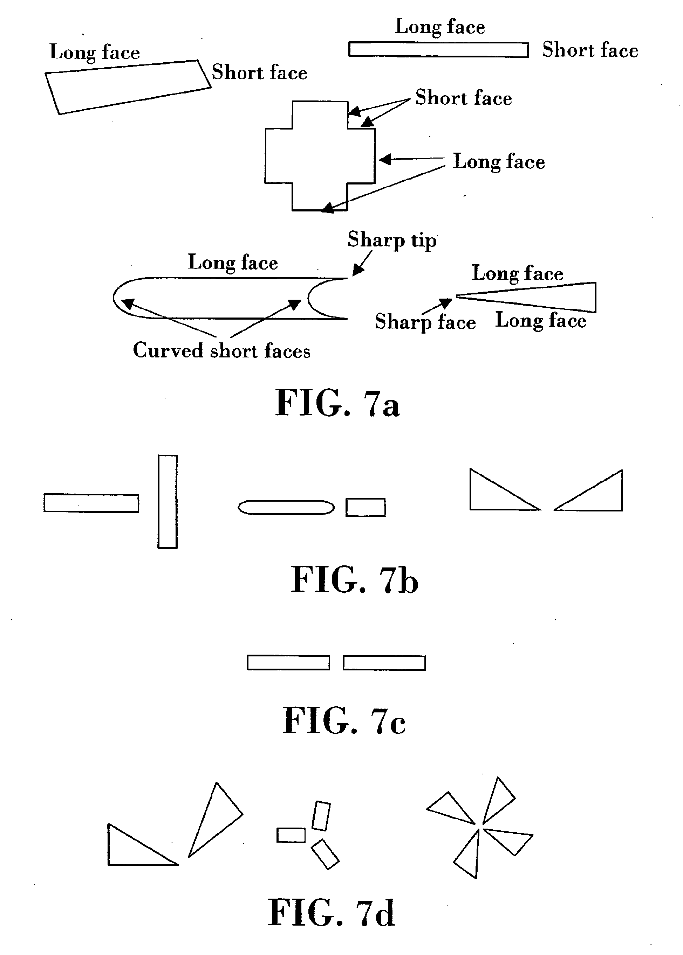

Preferably, plasmonic elements have two or more opposing faces, as illustrated on figures 7b-7d.

The method of the invention enables to achieve desired size of the plasmonic elements in a nanometer range, i.e. from 1 to 1000nm. In particular, the size in the vertical direction of the plasmonic elements, i.e. perpendicular to the substrate, are typically below 100nm, in order to decrease plasmon damping to the bulk, preferably ranges in between 20 and 60nm and more preferably is 40nm.

Plasmonic elements have long faces and short faces, which can be straight, curved or having sharp tips as illustrated, only by way of example, on figure 7a. Curved short faces may have radius of curvature between 0,1 - 10 nm or radius of curvature may be 0, i.e. long faces touch under an angle less than 90°. Preferable angle between long faces is less than 45°. In case of a sharp tip, angle between faces ranges in between 0,1 - 10°.

Horizontal dimensions of long faces of the plasmonic elements normally range from nanometers to millimeters (10 nm - 1 mm), preferably are in the range of 100 nm - 100 µm, while short faces are in nanometer range (0,1 nm -1 µm), preferably are in the range of 1 - 100 nm and especially in the range of 1 - 10 nm.

In one embodiment of the invention, the nanostructure contains two opposing faces with a separation in the range of between 0,1 - 100nm, where one of the opposing faces is a short or a curved face or a sharp tip or both opposing faces are short or curved faces or sharp tips, as illustrated on figure 7b.

Preferably, the separation between the two opposing faces is in the range of between 0,1 - 50 nm, and especially in the range of between 10 - 20 nm.

In another particular embodiment of the invention, the two opposing faces are sharp tips that are connected through a small connection in the range of between 0,1 - 10nm, preferably, the connection is only several atoms wide, i.e. in the range of between 0,1 - 1nm and most preferably, the connection is only a single atom wide.

Yet in another possible embodiment of the invention, the nanostructure consists of two or more of the above described elements that are arranged in such a way that their faces or tips are not entirely opposing but located in their vicinity in such a way that their mutual placement leads to increased field enhancement compared to a single element, as shown for example on figure 7d. Preferably, the nanostructure consists of multiple elements that share opposing faces or tips.

In one particular embodiment of the invention, separate plasmonic elements of the molecular plasmonic nanostructure, preferably constitute one or more plasmonic nanoantennas, an example of which is shown in figure 7c.

Whereas in another particular embodiment of the invention, plasmonic elements obtained by the process involving inverted pattern, as illustrated in figure 3, preferably form one or more nanostructured holes in a continuous film of plasmonic material, in a form of one or multiple ovals or circles or rectangles.

Yet another aspect of the invention refers to the use of the molecular plasmonic nanostructure in sensing and detection, light harvesting and energy conversion, photon sources, all-optical components including transistors, and electronic-optical interfacing.

Hereinafter, the present invention is described in more detail and specifically with reference to the examples, which however are not intended to limit its scope of protection, which is defined by the appended patent claims.

### EXAMPLES

### Example 1. Substrate preparation and electron-beam lithography.

Substrates for electron-beam lithography were prepared as follows: First, an 80nm layer of indium tin oxide (ITO) was deposited on a glass cover slide (thickness no.1) by electron-beam evaporation under a pressure between 10⁻⁵-10⁻⁶ Torr at a rate of 1 Å/s. The ITO layer was then homogenized by baking for over an hour at 350°C. An approximately 10nm film of Cr was subsequently deposited on the ITO substrate under a pressure between 10⁻⁵-10⁻⁶ Torr at a rate of 1 Å/s. As electron-beam resist material was used poly(methylmethacrylate) (PMMA) which was deposited in a 120-130nm thick layer by spin-coating from a 4wt%-solution in trichlorobenzene. The PMMA-layer was baked for three hours at 175°C. Electron-beam lithography was then performed with a beam current on the order of 0,12 nA, a voltage of 30kV and a spot size of 3,5. The important exposure parameters were the dot dose, fixed at 0.018 pAs, and the dot dwell time calculated from the measured beam current. After exposure, the resist was developed for a period of 30 seconds in MIBK:IPA (1:3) (MicroChem Corp.) and rinsed with isopropanol. A 40nm layer of gold was then thermally deposited under pressure between 10⁻⁵-10⁻⁶ Torr at 5 Å/s. A lift-off procedure using dichloromethane followed by an isopropanol rinsing bath allowed thereafter to get rid of the Au surplus and left only the nanoantennas. The sample was ready for Focused Ion Beam (FIB) milling.

### FIB milling.

A dual beam system (FEI NOVA600) was then used to first image the structure by electron beam microscopy, then to image it again with the ion beam at low magnification in order to take into account the drift between the two beams. Subsequently, the regions to be milled were defined, i.e. the gap region of the gold nanoantennas for different values of milling depth z. The z value depended on the current beam and magnification used, but also on the top layer thickness to cut off. In case of this example several z values were employed from 15 up to 22 nm, with complete local removal of the Cr layer only observed for z = 22 nm.

### Chemical functionalization.

All chemicals were used as supplied. Rhodamine-B-isothiocyanate (RhB, Sigma R1755-1G, mixed isomers) was linked to the silane coupling agent 3-aminopropyltriethoxysilane (APS, Sigma, 99%) by mixing 53 mg of RhB (0.01 mmol) with 69 mg of APS (0.28 mmol) in 10 ml of ethanol (Merck, absolute grade) under continuous stirring for several hours. Samples with the FIB-milled nanoantennas were put in a glass beaker containing 210 ml ethanol and 6 ml of ammonia (Baker, 28.8%). 3 M1 of the APS-RhB solution was added, followed by rigorous stirring for one minute to ensure rapid homogenization. The solution was then left under gentle stirring for 90 minutes. Samples were then immersed twice in clean ethanol solutions followed by thorough rinsing with ethanol. Plain glass cover slides subjected to the same procedure as a reference showed a faint pink colour due to surface coating with RhB.

### Example 2

### Method of the invention with a spacer growth

A silica spacer was grown by immersing the samples in ethanol solution containing water (6,0 M) and ammonia (1,0 M). Tetraethoxysilane was subsequently added under continuous stirring. The amount of tetraethoxysilane was chosen to achieve the desired thickness of the grown silica layer. The solution was then left under continuous stirring for about two hours, after which the samples were rinsed thoroughly with ethanol.

### Example 3 Characterization of the molecular plasmonic nanostructure

Gold (Au) nanostructures were constructed consisting of two short-end facing metallic bars with a small gap in between. Using a focused ion beam milling (FIB) a small hole was etched into the Cr-upper layer in the area between the two gold bars, thus exposing locally the ITO lower layer. The fluorescent dye Rhodamine-B-isothiocyanate (RITC) was covalently linked to the amino coupling agent 3-aminopropyltriethoxysilane (APS). The APS-RITC construct was then grafted onto the ITO surface through hydrolysis and condensation of the silane group. A top view of the final construct, showing the small functionalized area in between the Au bars is depicted in Figure 2.

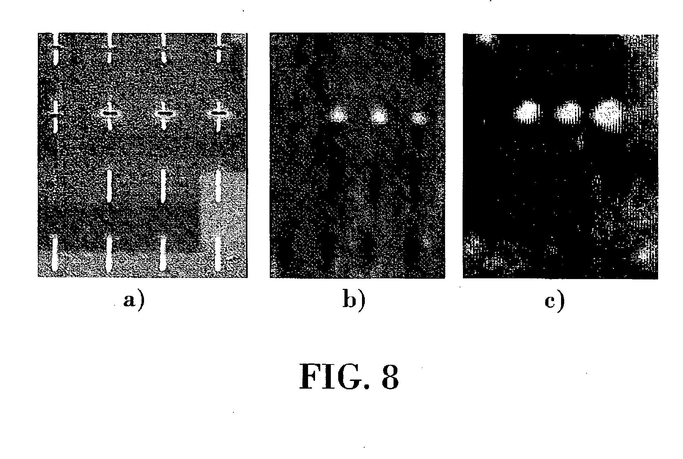

An example of an experimental realization is shown in Figure 8. Using FIBM several areas with lateral dimensions 50 x 200 nm and varying depth were etched in the Cr layer.

By tuning conditions of the surface functionalization reaction, coverage of this area can be varied from monolayer coverage to only few or single molecules.

In Figure 8 the following can be seen: (a) is a Scanning electron microscopy image of an array of gold nanoantennas (white vertical bars) on a Cr/ITO substrate after Focused Ion Beam milling. A gap has been milled in the middle of the antennas in the upper two rows, with ion beam dose increasing from the upper left corner to the right antenna in the second row. (b) shows the optical transmission and (c) the confocal fluorescence microscopy image of the same area after APS-RITC functionalization. In (b) some of the antennas are clearly visible as dark stripes. The three pronounced gaps in the second row show a drastically increased transmission due to complete milling of the Cr layer and exposure of the underlying ITO substrate. The same three spots are visible as bright fluorescence spots in (c) demonstrating selective grafting of the fluorescent dye RITC on the exposed ITO areas.

## Claims

1. A method of manufacturing a molecular plasmonic nanostructure, which comprises the steps of:
a) forming of two distinct layers of conductive material consisting of a layer of upper conductor (1, 9) and a layer of lower conductor (2),
b) fabrication of a plasmonic nanostructure onto a layer of upper conductor (1, 9) with the use of a charged particle beam technique,
c) etching the surface through the layer of upper
conductor (1, 9) with the use of a charged particle beam technique, thus exposing the desired area of a layer of lower conductor (2),
d) functionalising the exposed area with the use of desired molecular unit (6).

2. A method according to claim 1, which further comprises applying a surface coating (8) onto a layer of upper conductor (1, 9) after step (b).

3. A method according to claim 1 or 2, wherein step (b) comprises the steps of:
i) depositing a resist material (4) onto said layer of upper conductor (1),
ii) writing a pattern in said resist material (4) with the use of a charged particle beam lithography technique,
iii) developing said resist material (4),
iv) depositing a plasmonic material (5),
v) removing remaining resist material (4).

4. A method according to claim 3, wherein depositing of said resist material (4) from step (i) is carried out by spincoating technique.

5. A method according to claims 3 or 4, wherein charged particle beam lithography technique from step (ii) is electron beam lithography.

6. A method according to claim 1 or 2, wherein step (b) comprises the steps of:
i) depositing a plasmonic material (11) onto said layer of upper conductor (9),
ii) depositing a resist material (10) onto a formed layer of deposited plasmonic material (11),
iii) developing said resist material (10),
iv) writing a pattern in said resist material (10) with the use of a charged particle beam lithography technique,
v) etching the surface of exposed plasmonic material (11) with the use of a charged particle beam technique,
vi) removing remaining resist material (10).

7. A method according to claim 6, wherein step (ii) of depositing said resist material (10) is carried out by spincoating technique.

8. A method according to claim 6 or 7, wherein charged particle beam lithography technique from step (iv) is electron beam lithography.

9. A method according to any one of claims 6 to 8, wherein charged particle beam technique from step (v) is a reactive ion etching technique.

10. A method according to any one of claims 1-9, wherein charged particle beam technique from step (c) is focused ion beam milling.

11. A method according to any one of claims 1-10, wherein step (d) is preceded with grafting or adsorbing a spacer (7) onto the exposed area.

12. A method according to any one of claims 1 to 11, wherein the layers of upper conductor (1, 9) and of lower conductor (2) are coated onto a supporting substrate (3) or the layer of lower conductor (2) is the supporting substrate.

13. A method according to claim 12, wherein said lower conductor (2) has higher chemical affinity for a molecular unit (6) or a spacer (7), than the upper conductor (1, 9).

14. A method according to claim 12, wherein said upper conductor (1, 9) is selected from the group consisting of metal, metal oxide, doped semiconductor, conductive polymer and conductive carbon film.

15. A method according to Claim 14, wherein said upper conductor (1, 9) is selected from the group consisting of chromium, chromium oxide, titanium and titania.

16. A method according to claim 13, wherein said lower conductor (2) comprises conductive material, selected from the group consisting of metal, metal oxide, doped semiconductor, conductive polymer, and conductive carbon film.

17. A method according to claim 16, wherein said lower conductor (2) is a conductive material that is transparent at wavelengths in the range 400-700 nm.

18. A method according to claim 2, wherein said surface coating (8) consists of a polymer film or a self assembled monolayer.

19. A method according to claim 11, wherein the spacer (7) comprises an inorganic compound or one or more layers of alternating positively and negatively charged polyelectrolytes.

20. A method according to claim 19, wherein the spacer (7) is SiO₂.

21. A method according to any one of claims 3 or 6, wherein said plasmonic material (5, 11) is selected from the group consisting of p-type doped silicon, n-type doped silicon, gallium arsenide, gold and silver.

## Patentansprüche

1. Verfahren zum Herstellen einer molekularen, plasmonischen Nanostruktur, das folgende Schritte umfasst:
a) Ausbilden zweier unterschiedlicher Schichten eines leitfähigen Materials, das aus einer Schicht eines oberen Leiters (1, 9) und einer Schicht eines unteren Leiters (2) besteht,
b) Herstellung einer plasmonischen Nanostruktur auf einer Schicht des oberen Leiters (1, 9) unter Anwendung einer Ladungspartikelstrahltechnik,
c) Ätzen der Oberfläche durch die Schicht des oberen Leiters (1, 9) unter Anwendung einer Ladungspartikelstrahltechnik, wodurch der gewünschte Bereich einer Schicht des unteren Leiters (2) freigelegt wird, und
d) Funktionalisieren des freigelegten Bereiches unter Verwendung einer gewünschten molekularen Einheit (6).

2. Verfahren nach Anspruch 1, weiterhin umfassend das Aufbringen einer Oberflächenbeschichtung (8) auf eine Schicht des oberen Leiters (1, 9) nach Schritt (b).

3. Verfahren nach Anspruch 1 oder 2, wobei der Schritt (b) folgende Schritte umfasst:
i) Abscheiden eines Fotolackmaterials (4) auf der Schicht des oberen Leiters (1),
ii) Schreiben eines Musters in das Fotolackmaterial (4) unter Anwendung einer Ladungspartikelstrahl-Lithografietechnik,
iii) Entwickeln des Fotolackmaterials (4),
iv) Abscheiden eines plasmonischen Materials (5),
v) Entfernen des verbliebenen Fotolackmaterials (4).

4. Verfahren nach Anspruch 3, bei dem das Abscheiden des Fotolackmaterials (4) aus Schritt (i) unter Anwendung einer Aufschleudertechnik ausgeführt wird.

5. Verfahren nach Anspruch 3 oder 4, bei dem die Ladungspartikelstrahl-Lithografietechnik aus Schritt (ii) eine Elektronenstrahl-Lithografie ist.

6. Verfahren nach Anspruch 1 oder 2, bei dem der Schritt (b) folgende Schritte umfasst:
i) Abscheiden eines plasmonischen Materials (11) auf der Schicht des oberen Leiters (9),
ii) Abscheiden eines Fotolackmaterials (10) auf einer ausgebildeten Schicht des abgeschiedenen plasmonischen Materials (11),
iii) Entwickeln des Fotolackmaterials (10),
iv) Schreiben eines Musters in dem Fotolackmaterial (10) unter Anwendung einer Ladungspartikelstrahl-Lithografietechnik,
v) Ätzen der Oberfläche des freigelegten plasmonischen Materials (11) unter Anwendung einer Ladungspartikelstrahltechnik und
vi) Entfernen des verbliebenen Fotolackmaterials (10).

7. Verfahren nach Anspruch 6, bei dem der Schritt (ii) des Abscheidens des Fotolackmaterials (10) unter Anwendung einer Aufschleudertechnik ausgeführt wird.

8. Verfahren nach Anspruch 6 oder 7, bei dem die Ladungspartikelstrahl-Lithografietechnik aus Schritt (iv) die Elektronenstrahl-Lithografie ist.

9. Verfahren nach einem der Ansprüche 6 bis 8, bei dem die Ladungspartikelstrahltechnik aus Schritt (v) eine reaktive lonenätztechnik ist.

10. Verfahren nach einem der Ansprüche 1 bis 9, bei dem die Ladungspartikelstrahltechnik aus Schritt (c) das fokussierte lonenstrahlabtragen ist.

11. Verfahren nach einem der Ansprüche 1 bis 10, bei dem Schritt (d) das Aufpfropfen oder Adsorbieren eines Abstandshalters (7) auf den freigelegten Bereich vorausgeht.

12. Verfahren nach einem der Ansprüche 1 bis 11, bei dem die Schichten des oberen Leiters (1, 9) und des unteren Leiters (2) auf ein Trägersubstrat (3) beschichtet werden oder die Schicht des unteren Leiters (2) das Trägersubstrat ist.

13. Verfahren nach Anspruch 12, bei dem der untere Leiter (2) eine höhere chemische Affinität für eine molekulare Einheit (6) oder einen Abstandshalter (7) hat als der obere Leiter (1, 9).

14. Verfahren nach Anspruch 12, bei dem der obere Leiter (1, 9) aus der Gruppe gewählt ist, die aus Metall, Metalloxid, einem dotierten Halbleiter, einem leitfähigen Polymer und einem leitfähigen Kohlenstofffilm besteht.

15. Verfahren nach Anspruch 14, bei dem der obere Leiter (1, 9) aus der Gruppe gewählt ist, die aus Chrom, Chromoxid, Titan und Titandioxid besteht.

16. Verfahren nach Anspruch 13, bei dem der untere Leiter (2) ein leitfähiges Material enthält, das aus der Gruppe gewählt ist, die aus Metall, Metalloxid, einem dotierten Halbleiter, einem leitfähigen Polymer und einem leitfähigen Kohlefaserfilm besteht.

17. Verfahren nach Anspruch 16, bei dem der untere Leiter (2) ein leitfähiges Material ist, das bei Wellenlängen im Bereich zwischen 400 und 700 nm transparent ist.

18. Verfahren nach Anspruch 2, bei dem die Oberflächenbeschichtung (8) aus einer Polymerfolie oder einer selbst zusammengesetzten Monoschicht besteht.

19. Verfahren nach Anspruch 11, bei dem der Abstandshalter (7) eine anorganische Verbindung oder wenigstens eine Schicht abwechselnd positiv und negativ geladener Polyelektrolyte enthält.

20. Verfahren nach Anspruch 19, bei dem der Abstandshalter (7) SiO₂ ist.

21. Verfahren nach einem der Ansprüche 3 oder 6, bei dem das plasmonische Material (5, 11) aus der Gruppe gewählt ist, die aus einem p-Typ-dotierten Silizium, einem n-Typ-dotierten Silizium, Gallium-Arsenid, Gold und Silber besteht.

## Revendications

1. Procédé d'obtention d'une nanostructure plasmonique moléculaire comprenant les étapes consistant à :
a. former deux couches distinctes de matériau conducteur constituées par une couche d'un conducteur supérieur (1, 9) et une couche d'un conducteur inférieur (2),
b. fabriquer d'une nanostructure plasmonique sur la couche de conducteur supérieur (1, 9) en utilisant une technique de faisceaux de particules chargées,
c. attaquer la surface au travers de la couche de conducteur supérieur (1, 9), en utilisant une technique de faisceaux de particules chargées, en exposant la surface souhaitée de la couche de conducteur (2),
d. fonctionnaliser la surface exposée en utilisant l'unité moléculaire souhaitée (6).

2. Procédé conforme à la revendication 1, comprenant en outre une étape consistant à appliquer un revêtement de surface (8) sur la couche du conducteur supérieur (1, 9) après l'étape (b).

3. Procédé conforme à la revendication 1 ou à la revendication 2, selon lequel l'étape (b) renferme les étapes consistant à :
i. déposer un matériau résistant (4) sur la couche de conducteur supérieur (1),
ii. écrire un motif dans le matériau résistant (4) en utilisant une technique de lithographie à faisceau de particules chargées,
iii. développer ce matériau résistant (4)
iv. déposer un matériau plasmonique (5),
v. éliminer le matériau résistant (4) restant.

4. Procédé conforme à la revendication 3, selon lequel le dépôt du matériau résistant (4) de l'étape (i) est mis en oeuvre par la technique d'enduction centrifuge.

5. Procédé conforme à la revendication 3 ou à la revendication 4, selon lequel la technique de lithographie à faisceau de particules chargées de l'étape (ii) est la lithographie à faisceau d'électrons.

6. Procédé conforme à la revendication 1 ou à la revendication 2, selon lequel l'étape (b) renferme les étapes consistant à :
i. déposer un matériau plasmonique (11) sur la couche de conducteur supérieur (9),
ii. déposer un matériau résistant (10) sur une couche formée de matériau plasmonique déposé (11),
iii. développer le matériau résistant (10),
iv. écrire un motif dans le matériau résistant (10) en utilisant une technique de lithographie à faisceau de particules chargées,
v. attaquer la surface du matériau plasmonique exposé (11) en utilisant une technique de faisceau de particules chargées,
vi. éliminer le matériau résistant (10) restant.

7. Procédé conforme à la revendication 6, selon lequel l'étape (ii) de dépôt du matériau résistant (10) est mise en oeuvre par la technique d'enduction centrifuge.

8. Procédé conforme à la revendication 6 ou à la revendication 7, selon lequel la technique de lithographie à faisceau de particules chargées de l'étape (iv) est la lithographie à faisceau d'électrons.

9. Procédé conforme à l'une quelconque des revendications 6 à 8, selon lequel la technique de faisceau de particules chargées de l'étape (v) est une technique d'attaque ionique réactive.

10. Procédé conforme à l'une quelconque des revendications 1 à9, selon lequel la technique de faisceau de particules chargées de l'étape (c) est le broyage par faisceau d'ions focalisé.

11. Procédé conforme à l'une quelconque des revendications 1 à 10, selon lequel l'étape (d) est précédé d'une étape consistant à greffer ou à absorber un élément d'espacement (7) sur la surface exposée.

12. Procédé conforme à l'une quelconque des revendications 1 à 11, selon lequel les couches de conducteur supérieur (1, 9) et de conducteur inférieur (2) sont revêtues sur un substrat support (3) ou la couche de conducteur inférieur (2) est le substrat support.

13. Procédé conforme à la revendication 12, selon lequel le conducteur inférieur (2) a une affinité chimique pour une unité moléculaire (6) ou un élément d'espacement (7) supérieure à celle du conducteur supérieur (1, 9).

14. Procédé conforme à la revendication 12, selon lequel le conducteur supérieur (1, 9) est choisi dans le groupe consistant en un métal, un oxyde métallique, un semi conducteur dopé, un polymère conducteur et un film de carbone conducteur.

15. Procédé conforme à la revendication 14, selon lequel le conducteur supérieur (1, 9) est choisi dans le groupe formé par le chrome, l'oxyde de chrome, le titane et le dioxyde de titane.

16. Procédé conforme à la revendication 13, selon lequel le conducteur inférieur (2) comprend un matériau conducteur choisi dans le groupe formé par un métal, un oxyde métallique, un semi conducteur dopé, un polymère conducteur et un film de carbone conducteur.

17. Procédé conforme à la revendication 16, selon lequel le conducteur inférieur (2) est un matériau conducteur qui est transparent à des longueurs d'ondes comprises dans la plage de 400-700 nm.

18. Procédé conforme à la revendication 2, selon lequel le revêtement de surface (8) est constitué par un film polymère ou une monocouche auto assemblée.

19. Procédé conforme à la revendication 11, selon lequel l'élément d'espacement (7) renferme un composé inorganique ou au moins une couche de poly-électrolytes alternativement chargé positivement et négativement.

20. Procédé conforme à la revendication 19, selon lequel l'élément d'espacement (7) est SiO2.

21. Procédé conforme à l'une quelconque des revendications 3 et 6, selon lequel le matériau plasmonique (5, 11) est choisi dans le groupe formé par le silicium dopé p, le silicium dopé n, l'arsénure de gallium, l'or et l'argent.
